# FASCICULE DE BREVET EUROPEEN

(11) **EP 0 660 652 B1**
(45) Date de publication et mention de la délivrance du brevet: **04.02.1998**
(21) Numéro de dépôt: 94402857.0
(22) Date de dépôt: 12.12.1994
(51) Int. Cl.: H05K 7/14

(54) **Variateur électronique de vitesse**
Elektronischer Regelantrieb
Electronic variable-speed drive

(30) Priorité: 22.12.1993 FR 9315622
(43) Date de publication de la demande: 28.06.1995
(73) Titulaire: SCHNEIDER ELECTRIC SA, 92100 Boulogne Billancourt (FR)
(72) Inventeur: Cerri, Jacques, F-78130 Chapet (FR); Rix, Philippe, F-75015 Paris (FR); Mercier, Ghislaine, F-78360 Montesson (FR); Mansuy, Philippe, F-95000 Cergy (FR)
(74) Mandataire: Saint Martin, René

(56) Documents cités:
- EP-A- 0 103 412
- EP-A- 0 356 991
- DE-A- 3 412 510
- GB-A- 2 271 679
- US-A- 4 908 738

## Description

La présente invention se rapporte à un variateur électronique de vitesse comprenant, dans un coffret pourvu d'un couvercle ouvrant, d'une part un ensemble de puissance alimenté par un réseau alternatif et délivrant une tension sous le contrôle d'interrupteurs statiques de puissance et d'autre part un ensemble électronique de commande des interrupteurs statiques.

Les variateurs électroniques de vitesse sont couramment utilisés en association avec des moteurs à courant continu ou à courant alternatif pour entraîner ces moteurs à vitesse variable.

Un variateur électronique est connu du document EP-A-0 356 991.

Les variateurs de vitesse appelés convertisseurs de fréquence qui sont destinés à contrôler la vitesse des moteurs alternatifs assurent la fourniture, à partir du réseau alternatif monophasé ou triphasé, d'une tension alternative de valeur efficace et de fréquence variables suivant une loi préétablie. Ces convertisseurs de fréquence comprennent essentiellement d'une part un redresseur qui fournit une tension continue à un filtre capacitif de lissage (convertisseur alternatif-continu) et d'autre part un onduleur à transistors de puissance (convertisseur continu-alternatif) alimenté par ladite tension continue filtrée.

Le redresseur est un pont redresseur alimenté par un réseau monophasé ou triphasé. L'onduleur est raccordé aux enroulements de phase du moteur et récrée, à partir de la tension continue fournie par le redresseur, une tension alternative.

La technique de commande des transistors de puissance est connue sous le nom de Modulation de Largeur d'Impulsions (en abrégé MLI- en anglais PWM pour Pulse Width Modulation), le but étant de générer une tension aussi proche que possible d'une sinusoïde.

Le brevet EP 103.412 ou le brevet DE 3.412.510 décrivent des variateurs électroniques de vitesse. Les variateurs connus n'assurent pas un degré de protection suffisante.

La présente invention a pour but de fournir un variateur de vitesse dont la protection est étudiée de manière à permettre l'accès du personnel de maintenance ou de dépannage à des parties fonctionnelles du variateur lorsque celui-ci est en fonctionnement. Il permet de mettre en place ou retirer ou remplacer des cartes optionnelles, que le produit soit ou ne soit pas sous tension, avec une grande sécurité. La protection est étudiée pour que l'introduction de particules métalliques ou de poussières conductrices en chute verticale ne puisse pas perturber le fonctionnement tout en garantissant une protection des personnes et en permettant la dissipation thermique des éléments chauffants internes du variateur. Le coffret assure une protection de type IP30 lorsque le couvercle est fermé et de type IP20 lorsque le couvercle est ouvert.

Le variateur électronique selon l'invention est caractérisé par le fait que le coffret contient, derrière le couvercle, un capot de protection qui protège l'ensemble électronique de commande et l'ensemble de puissance placés derrière de manière à protéger, quand le couvercle est ouvert, les utilisateurs vis à vis de ces ensembles de commande et de puissance, et par le fait que le capot de protection présente des moyens pour monter entre le capot et le couvercle, un module électronique optionel se connectant à l'ensemble électronique de commande.

Selon une caractéristique, le capot de protection présente des moyens pour monter, entre le capot et le couvercle, un module électronique optionnel se connectant à l'ensemble électronique de commande.

Selon une caractéristique, le capot de protection présente au moins une fenêtre de passage permettant l'accès d'au moins un connecteur monté sur une carte de l'ensemble électronique de commande.

Selon une caractéristique, le capot de protection porte des moyens de signalisation qui débouchent dans une fenêtre du couvercle.

Selon une caractéristique, le couvercle de l'enveloppe comporte une fenêtre dans laquelle se loge une console de dialogue.

Selon une caractéristique, le capot de protection présente un rebord fermé qui est destiné à recevoir la console de dialogue et assure l'étanchéité sur le pourtour de la fenêtre.

Selon une caractéristique, le module électronique optionnel est constitué par une carte électronique logée dans une enveloppe isolante et est pourvu d'un connecteur destiné à s'engager dans une fenêtre du capot de protection.

Selon une autre caractéristique, le coffret se compose d'une partie avant contenant la partie électronique et d'une partie arrière qui contient l'ensemble de refroidissement et est fermée par une plaque-support de refroidisseur, ces deux parties étant assemblées de manière démontable.

L'invention va maintenant être décrite avec plus de détail en se référant à un mode de réalisation donné à titre d'exemple et représenté par les dessins annexés sur lesquels:

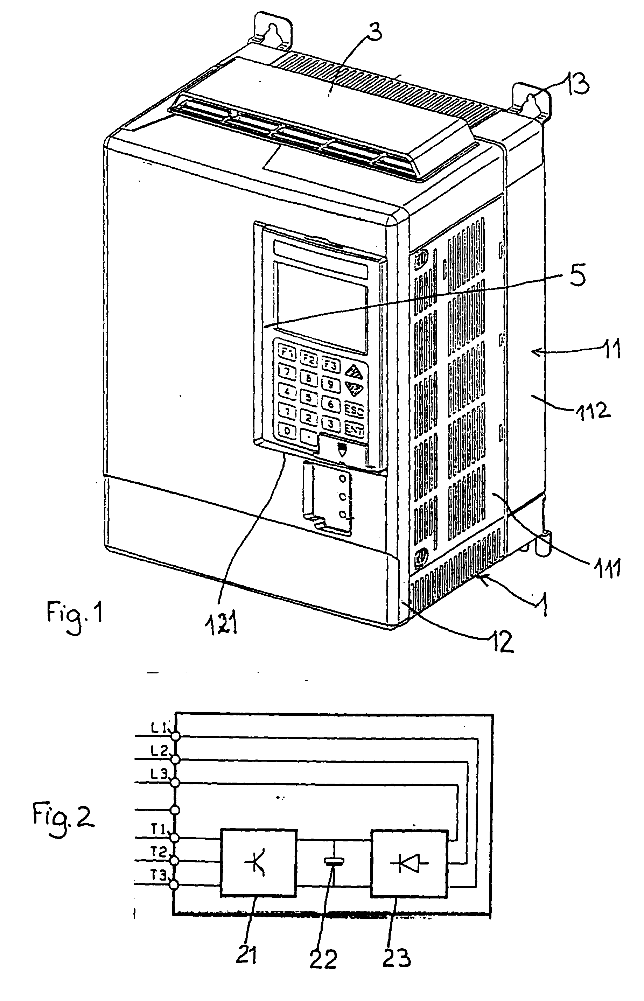

- la figure 1 est une vue extérieure en perspective du variateur électronique selon l'invention;
- la figure 2 est un schéma fonctionnel du variateur électronique;

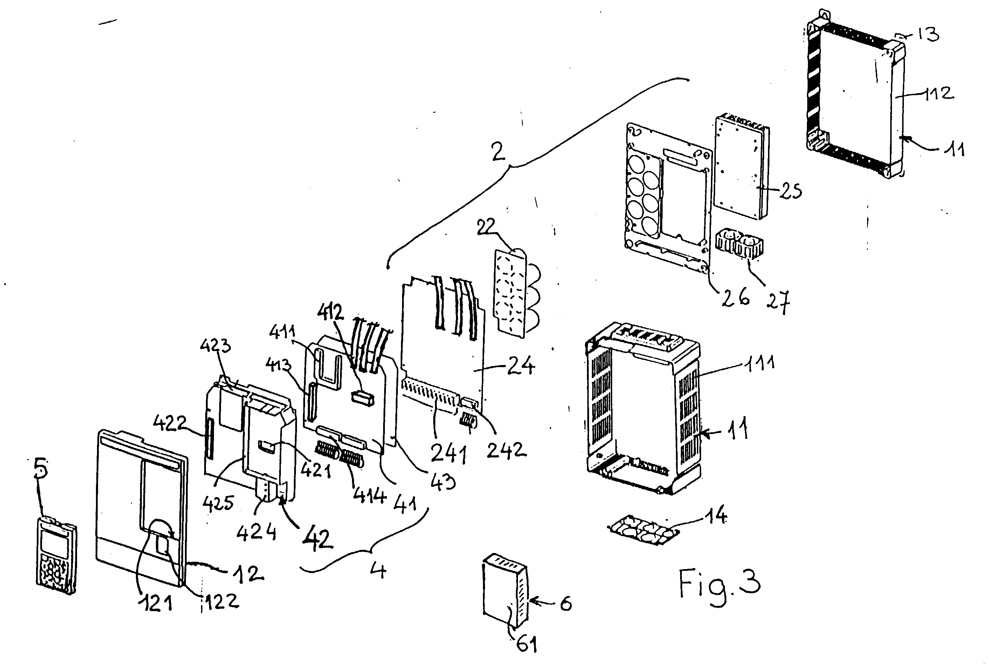

- la figure 3 est une vue éclatée du variateur de la figure 1.

Le variateur électronique de vitesse représenté sur les dessins est un convertisseur de fréquence adapté à un moteur asynchrone.

Ce variateur électronique de vitesse présente un coffret 1 constitué par un corps de coffret 11 et par un couvercle 12 monté pivotant, autour d'axes de pivotement verticaux, sur le corps de coffret à l'aide de charnières latérales. Après fermeture du couvercle, celui-ci se verrouille sur le corps de coffret à l'aide d'une serrure de type connu. Le coffret 1 se fixe sur un support à l'aide de pattes de fixation 13 fixées à l'arrière du coffret. Le côté inférieur du coffret comporte une plaque passe-câbles 14. Les côtés du coffret présentent des ouïes d'aération.

Le coffret 1 contient un ensemble électronique de puissance 2 qui comprend un onduleur 21 relié par des capacités 22 de filtrage à un redresseur à diodes 23 relié par des bornes L₁, L₂, L₃ aux conducteurs de phase du réseau alternatif triphasé. Chaque bras de l'onduleur est équipé de deux interrupteurs statiques de puissance associés à des diodes de récupération. Les points milieux des couples d'interrupteurs sont reliés par des bornes T₁, T₂, T₃ aux enroulements de phase du moteur. Ces interrupteurs sont constitués par des transistors bipolaires ou MOS, soit par des composants MOS bipolaires tels que ceux connus sous la désignation IGBT, soit par des thyristors blocables du genre GTO soit par d'autres composants blocables analogues.

Les différents interrupteurs de puissance et les diodes sont montés sur une carte de puissance 24. Les bornes d'entrée (L₁, L₂, L₃) faisant la connexion entre le redresseur à diodes et les conducteurs de phase ainsi que les bornes T₁, T₂, T₃ servant à la connexion aux phases du moteur constituent un bornier 241 qui est fixé sur la carte de puissance 24 et qui comprend des moyens de protection des bornes. La carte de puissance 24 se monte sur un support de refroidisseur 26 portant un refroidisseur 25 servant à refroidir les interrupteurs statiques de puissance. Le support de refroidisseur 26 délimite une chambre à l'arrière du coffret et des ventilateurs 27 ventilent l'arrière du refroidisseur 25 de manière à augmenter le refroidissement. Un bornier 242 de bornes de commande est fixé à la carte 24.

Le variateur peut être paramétré par une console ou un boîtier de dialogue 5 de type graphique qui affleure dans une fenêtre 121 du couvercle 12.

Le coffret contient un ensemble électronique de commande 4 qui pilote les interrupteurs statiques montés sur la carte de puissance 24. Cet ensemble électronique de commande comprend une carte de contrôle 41 qui est reliée électriquement à la carte de puissance 24. La carte de puissance 24 et la carte de commande 41 sont séparées par un écran électrostatique 43.

La carte de commande 41 porte un lecteur de carte 411 adapté à une carte au standard PCMCIA (Personal Computer Memory Card International Association") ou tout autre standard similaire, un connecteur 412 destiné à la connexion de la console de dialogue 5 et un connecteur 413 destiné à la connexion d'un module additif optionnel 6. La carte porte également un bornier 414 de bornes de commande.

Le coffret 1 contient un capot de protection en plastique isolant 42 qui cache et protège, lorsqu'on ouvre le couvercle 12, l'ensemble électronique de commande et l'ensemble de puissance. Ce capot de protection 42 ferme en grande partie le corps de coffret et est adjacent à la carte de commande 41. Il apparaît dès que l'on ouvre le couvercle 12 et protège l'opérateur contre les chocs électriques. Les bornes de puissance 241 qui restent accessibles sur le côté du capot de protection sont des bornes protégées et l'ensemble est donc protégé.

Le module additif optionnel 6 se loge entre le capot de protection 42 et le couvercle 12.

Le capot de protection 42 présente une fenêtre de passage 423 permettant l'engagement d'une carte PCMCIA dans le connecteur 411, une fenêtre 421 permettant l'accès au connecteur 412 et une fenêtre 422 permettant l'accès au connecteur 413. La fenêtre 421 permet le passage du connecteur disposé à l'arrière de la console de dialogue 5 pour l'embrochage sur le connecteur 412. La fenêtre 422 permet le passage du connecteur disposé à l'arrière du module additif 6 pour l'embrochage sur le connecteur 413.

Le capot de protection 42 porte des moyens de signalisation 424 qui débouchent dans une fenêtre 122 découpée dans le couvercle 12. Le capot 42 présente un rebord fermé 425 qui est destiné à recevoir la console de dialogue 5 et assure l'étanchéité sur le pourtour de la fenêtre 121.

Le module additif optionnel 6 qui se monte entre le capot 42 et le couvercle 12 est constitué d'une carte électronique montée dans une enveloppe 61 protégeant d'une part les composants électroniques de la carte contre les chocs et les décharges électrostatiques, d'autre part les personnes contre les contacts directs de parties sous tension. Cette enveloppe 61 permet la mise en place, l'enlèvement ou le remplacement des options, avec une garantie de sécurité, que le variateur soit ou ne soit pas sous tension.

Le coffret 11 comporte sur son côté supérieur, au dessus des ouïes de ventilation, un écran 3 en plastique qui évite l'introduction de particules métalliques ou de poussières conductrices en chute verticale tout en garantissant une protection des personnes et en permettant la dissipation thermique des éléments chauffants internes du variateur. Cet écran 3 ménage un canal d'aération au dessus des ouïes de ventilation de manière à permettre la circulation d'air tout en empêchant le passage de particules.

Le coffret 11 se compose, à l'avant, d'un cadre en plastique 111 et à l'arrière d'un fond métallique 112 assemblés l'un à l'autre de manière démontable. Le cadre 11 contient la partie électronique (partie puissance et partie commande). Le fond 112 contient le refroidisseur et les composants associés et il est fermé par la plaque-support de refroidisseur 26.

Le cadre 111 qui contient la partie électronique (puissance et commande) supporte la carte de puissance 24, la carte de commande 41, l'écran 43 et le capot de protection 42. Les cartes ou parties constitutives de l'électronique sont fixées à l'intérieur du cadre 111.

La partie arrière 112 contenant l'équipement de refroidissement peut se désolidariser de la partie avant 111 contenant l'électronique. Cet agencement permet de déporter les parties chauffantes à l'extérieur d'une enveloppe étanche.

Pour réaliser le montage, il faut réaliser une ouverture rectangulaire dans une paroi de l'enveloppe. Un joint d'étanchéité est intercalé entre le cadre 111 et la paroi pour assurer l'étanchéité et les deux parties 111 et 112 sont montées de part et d'autre de la paroi. Les deux parties sont finalement assemblées sur la paroi par des vis ce qui comprime le joint d'étanchéité.

Il est bien entendu que l'on peut sans sortir du cadre de l'invention imaginer des variantes et des perfectionnements de détail et de même envisager l'emploi de moyens équivalents.

## Revendications

1. Variateur électronique de vitesse comprenant, dans un coffret (1) pourvu d'un couvercle ouvrant (12), d'une part un ensemble de puissance (2) alimenté par un réseau alternatif et délivrant une tension sous le contrôle d'interrupteurs statiques de puissance et d'autre part un ensemble électronique de commande (4) des interrupteurs statiques, caractérisé par le fait que le coffret (1) contient, derrière le couvercle (12), un capot de protection (42) qui protège l'ensemble électronique de commande (4) et l'ensemble de puissance (2) placés derrière de manière à protéger, quand le couvercle (12) est ouvert, les utilisateurs vis à vis de ces ensembles de commande et de puissance et par le fait que le capot de protection (42) présente des moyens pour monter, entre le capot et le couvercle, un module électronique optionnel (6) se connectant à l'ensemble électronique de commande.

2. Variateur de vitesse selon la revendication 1, caractérisé par le fait que le module électronique optionnel (6) est constitué par une carte électronique logée dans une enveloppe isolante (61) et est pourvu d'un connecteur destiné à s'engager dans une fenêtre du capot de protection.

3. Variateur selon la revendication 1 ou 2, caractérisé par le fait que le capot interne (42) présente au moins une fenêtre (421, 422, 423) permettant l'accès à au moins un connecteur (411, 412, 413) monté sur une carte (41) de l'ensemble électronique de commande.

4. Variateur selon l'une quelconque des revendications précédentes, caractérisé par le fait que le capot de protection (42) porte des moyens de signalisation (424) qui débouchent dans une fenêtre (122) découpée dans la couvercle (12).

5. Variateur selon l'une quelconque des revendications précédentes, caractérisé par le fait que le couvercle (12) du enveloppe comporte une fenêtre (121) dans laquelle se loge une console de dialogue (5).

6. Variateur selon la revendication 5, caractérisé par le fait que le capot de protection (42) présente un rebord fermé (425) qui est destiné à recevoir la console de dialogue (5) et assure l'étanchéité sur le pourtour de la fenêtre (121).

7. Variateur de vitesse selon l'une quelconque des revendications précédentes, caractérisé par le fait que le coffret (11) se compose d'une partie avant (111) contenant la partie électronique et d'une partie arrière (112) qui contient l'ensemble de refroidissement et est fermée par une plaque-support de refroidisseur (26), ces deux parties étant assemblées de manière démontable.

## Patentansprüche

1. Elektronischer Regelantrieb mit innerhalb eines mit einem öffnenden Deckel (12) ausgerüsteten Gehäuses (1) einerseits einer Leistungsbaugruppe (2), die von einem Wechselstromnetz versorgt wird und unter der Kontrolle von statischen Leistungsschaltern eine Spannung liefert, und andererseits einer Steuerelektronikbaugruppe (4) der statischen Schalter, dadurch gekennzeichnet, daß das Gehäuse (1) hinter dem Deckel (12) eine Schutzhaube (42) enthält, die die dahinter angeordnete Steuerelektronikbaugruppe (4) und Leistungsbaugruppe (2) schützt, um die Verwender bei geöffnetem Deckel (12) vor diesen Steuer- und Leistungsbaugruppen zu schützen, und daß die Schutzhaube (42) Mittel aufweist, um zwischen der Haube und dem Deckel ein optionelles Elektronikmodul (6) zu montieren, das an die Steuerelektronikbaugruppe angeschlossen wird.

2. Regelantrieb nach Anspruch 1, dadurch gekennzeichnet, daß das optionelle Elektronikmodul (6) aus einer in einem isolierenden Mantel (61) angeordneten Elektronikkarte besteht und einen Steckverbinder zur Einführung in ein Fenster der Schutzhaube umfaßt.

3. Regelantrieb nach Anspruch 1 oder 2, dadurch gekennzeichnet, daß die interne Haube (42) mindestens ein Fenster (421, 422, 423) aufweist, das den Zugriff auf mindestens einen auf einer Karte (41) der Steuerelektronikbaugruppe montierten Steckverbinder (411, 412, 413) ermöglicht.

4. Regelantrieb nach einem der vorstehend genannten Ansprüche, dadurch gekennzeichnet, daß die Schutzhaube (42) Anzeigemittel (424) trägt, die in einem im Deckel (12) ausgeschnittenen Fenster (122) münden.

5. Regelantrieb nach einem der vorstehend genannten Ansprüche, dadurch gekennzeichnet, daß der Deckel (12) des Mantels ein Fenster (121) für den Einsatz einer Dialogkonsole (5) umfaßt.

6. Regelantrieb nach Anspruch 5, dadurch gekennzeichnet, daß die Schutzhaube (42) einen geschlossenen Rand (425) aufweist, der die Dialogkonsole aufnehmen soll und die Dichtheit am Fensterumfang (121) gewährleistet.

7. Regelantrieb nach einem der vorstehend genannten Ansprüche, dadurch gekennzeichnet, daß das Gehäuse (11) aus einem vorderen Teil (111) mit dem elektronischen Teil und einem hinteren Teil (112) mit der Kühlbaugruppe, der von einer Kühlertragplatte (26) geschlossen wird, besteht, wobei diese beiden Teile demontierbar zusammengebaut sind.

## Claims

1. Electronic variable speed drive including, in a cabinet having an opening door, a power system supplied with power from an AC line voltage and delivering a voltage under the control of solid state power switches and an electronic control system controlling said solid state switches, in which variable speed drive said cabinet contains, behind said door, a protective cover to protect the electronic control system and the power system which are disposed behind it and which, when said door is open, protects users from said control and power systems, and said protective cover has means for mounting between it and said door an optional electronic module which connects to said electronic control system.

2. Variable speed drive according to claim 1 wherein said optional electronic module is an electronic circuit board housed in an insulative container and provided with a connector adapted to be inserted into a window in said protective cover.

3. Variable speed drive according to claim 1 wherein said protective cover incorporates at least one window enabling access to at least one connector mounted on a circuit board of said electronic control system.

4. Variable speed drive according to claim 1 wherein said protective cover carries signalling means which show through a window in said door.

5. Variable speed drive according to claim 1 wherein said door incorporates a window in which is housed a dialog console.

6. Variable speed drive according to claim 5 wherein said protective cover has a closed rim which is adapted to receive said dialog console and provides a seal to the perimeter of said window.

7. Variable speed drive according to claim 1 wherein said cabinet comprises a front part containing the electronic system and a rear part containing the cooling system and is closed by a heatsink support plate, said two parts being assembled together in a demountable manner.
